# EUROPÄISCHE PATENTSCHRIFT

(11) **EP 4 111 220 B1**
(45) Veröffentlichungstag und Bekanntmachung des Hinweises auf die Patenterteilung: **09.04.2025**
(21) Anmeldenummer: 21706906.1
(22) Anmeldetag: 18.02.2021
(51) Int. Cl.: G01R 31/392

(54) **VERFAHREN ZUM BESTIMMEN EINES ALTERUNGSZUSTANDS MINDESTENS EINES ELEKTROCHEMISCHEN ENERGIESPEICHERS**
METHOD FOR DETERMINING A STATE OF HEALTH OF AT LEAST ONE ELECTROCHEMICAL ENERGY STORAGE DEVICE
PROCÉDÉ DE DÉTERMINATION D'UN ÉTAT DE SANTÉ D'AU MOINS UN DISPOSITIF DE STOCKAGE D'ÉNERGIE ÉLECTROCHIMIQUE

(30) Priorität: 28.02.2020 DE 102020202561
(43) Veröffentlichungstag der Anmeldung: 04.01.2023
(73) Patentinhaber: Robert Bosch GmbH, 70442 Stuttgart (DE)
(72) Erfinder: WOLL, Christoph, 70839 Gerlingen (DE); SIMONIS, Christian, 71229 Leonberg (DE)
(86) Internationale Anmeldenummer: PCT/EP2021/053977
(87) Internationale Veröffentlichungsnummer: WO 2021/170476

(56) Entgegenhaltungen:
- EP-A2- 1 845 386
- WO-A1-2019/234390
- US-A1- 2015 293 181
- US-A1- 2020 036 197

## Beschreibung

Die Erfindung geht aus von einem Verfahren zum Bestimmen eines Alterungszustands mindestens eines elektrochemischen Energiespeichers, einem Diagnosegerät, einem Computerprogramm sowie einer Verwendung des Diagnosegeräts gemäß dem Oberbegriff der unabhängigen Ansprüche.

### Stand der Technik

Ein Alterungszustand (State of Health, SOH) einer Batterie, dessen Werte in einer Batteriesteuereinheit (Battery Control Unit, BCU) berechnet und gespeichert sind, wird beispielsweise in einer Autowerkstatt im Zuge einer Inspektion eines elektrisch antreibbaren Fahrzeugs umfassend die Batterie über eine Diagnoseschnittstelle (On-Board-Diagnose-Schnittstelle, OBD-Schnittstelle) mit einem Diagnosegerät ausgelesen.

Diese Werte wurden während oder nach Fahrzyklen, während oder nach Ladevorgängen, in dynamischen oder stationären Zuständen, zu unterschiedlichen Bedingungen, je nach SOH-Algorithmus bestimmt.

Jeder Hersteller verwendet ein anderes Verfahren, teilweise gibt es sogar Unterschiede zwischen den gleichen Fahrzeug- oder Batteriemodellen und die Werkstätten verlassen sich auf den Wert des Alterungszustands mit einer entsprechend großen Un-/Genauigkeit.

Das Dokument US 2010/090650 offenbart Systeme und Verfahren zur genauen Charakterisierung der thermodynamischen und Materialeigenschaften von Elektroden und elektrochemischen Energiespeicher- und Energieumwandlungssystemen.

Das Dokument CN 106526486 offenbart ein Verfahren zur Erkennung des Alterungsgrades einer Lithiumbatterie.

Das Dokument US 2020/036197 A1 offenbart ein Batterieverwaltungssystem, umfassend eine Lade-/Entladeeinheit, die dazu konfiguriert ist, eine Batterie zu laden oder zu entladen, wobei die Batterie konfiguriert ist, um sich betriebsbereit zu entladen, um eine externe Vorrichtung mit Strom zu versorgen; eine Erfassungseinheit, die eine Spannung, einen Entladestrom und eine Entladedauer der Batterie während des Entladens der Batterie erfasst; eine Berechnungseinheit, die eine Lade-/Entladefähigkeit der Batterie gemäß der Spannung, dem Entladestrom und der Entladedauerzeit bestimmt, wobei die Lade-/Entladefähigkeit der Batterie einen Gesundheitszustand (SOH), einen Ladezustand (SOC) oder ein Lebensende der Batterie umfasst.

Es ist Aufgabe der vorliegenden Erfindung, den Stand der Technik weiter zu verbessern. Diese Aufgabe wird gelöst durch die Merkmale der unabhängigen Ansprüche.

### Offenbarung der Erfindung

### Vorteile der Erfindung

Die erfindungsgemäße Vorgehensweise mit den kennzeichnenden Merkmalen der unabhängigen Ansprüche weist demgegenüber den Vorteil auf, dass das Verfahren zum Bestimmen des Alterungszustands mindestens eines elektrochemischen Energiespeichers folgende erfindungsgemäße Schritte umfasst:
a) Erfassen einer Spannungsgröße, die eine elektrische Spannung des elektrochemischen Energiespeichers repräsentiert;
b) Vergleichen der erfassten Spannungsgröße mit einer vorgegebenen Soll-Spannungsgröße;
c) Erzeugen von Signalen zum Laden und/oder Entladen des elektrochemischen Energiespeichers basierend auf dem Ergebnis des Vergleichs;
d) Entladen des elektrochemischen Energiespeichers mit kleinen elektrischen Strömen, mit 0,1C bis 0,5C Entladerate, für eine vorgegebene Zeitdauer;
e) Erfassen der Spannungsgröße während des Entladens und Bestimmen eines Spannungsgradienten der erfassten Spannungsgröße für die vorgegebene Zeitdauer;
f) Vergleichen des Spannungsgradienten mit vorgegebenen Soll-Spannungsgradienten;
g) Bestimmen des Alterungszustands des elektrochemischen Energiespeichers basierend auf dem Ergebnis des Vergleichs;

Dadurch wird der Alterungszustand des elektrochemischen Energiespeichers bei definiertem Ladezustand hochpräzise bestimmt, wodurch eine zuverlässige Lebensdauervorhersage und Wirtschaftlichkeitsaussage für den elektrochemischen Energiespeicher getroffen werden kann, beispielsweise bei Reparatur oder Tausch des elektrochemischen Energiespeichers.

Weiter vorteilhaft ist, dass das erfindungsgemäße Verfahren als Standard-Testverfahren für elektrochemische Energiespeicher mit charakteristischem Spannungsverlauf eingesetzt werden kann. Dadurch wird auch eine Vergleichbarkeit von unterschiedlichen elektrochemischen Energiespeichern erreicht, was insbesondere für mögliche Second-Life-Anwendungen der Energiespeicher interessant ist.

Weitere vorteilhafte Ausführungsformen sind Gegenstand der Unteransprüche.

Ferner umfasst das Verfahren folgende vorteilhafte Schritte:

| | |
|---|---|
| a.1) | Erfassen einer Temperaturgröße, die eine Temperatur des elektrochemischen Energiespeichers repräsentiert; |
| a.2) | Vergleichen der erfassten Temperaturgröße mit einer vorgegebenen Soll-Temperaturgröße; |
| a.3) | Erzeugen von Signalen zum Heizen und/oder Kühlen des elektrochemischen Energiespeichers basierend auf dem Ergebnis des Vergleichs; |

Dadurch kann das erfindungsgemäße Verfahren bei fest definierten Temperaturen durchgeführt werden, wodurch keine Temperaturregelung durch den elektrochemischen Energiespeicher erforderlich ist.

Ferner umfasst das Verfahren folgenden vorteilhaften Schritt:

| | |
|---|---|
| c.1) | Warten einer vorgegebenen Dauer zum Relaxieren des elektrochemischen Energiespeichers; |

Dadurch kann das erfindungsgemäße Verfahren bei definierten und nahezu gleichen Bedingungen durchgeführt werden, wodurch eine höhere Genauigkeit und Vergleichbarkeit gegenüber dem Stand der Technik erreicht wird.

Ferner umfasst das Verfahren folgende vorteilhafte Schritte:

| | |
|---|---|
| e.1) | Entladen des elektrochemischen Energiespeichers mit kleinen elektrischen Strömen, mit 0,1C bis 0,5C Entladerate, für eine weitere vorgegebene Zeitdauer; |
| e.2) | Mindestens einmaliges Wiederholen der Schritte d) und e); |
| e.3) | Bestimmen eines Spannungsgradienten aus einem Mittelwert der bestimmten Spannungsgradienten; |

Dadurch kann das erfindungsgemäße Verfahren vollautomatisch durchgeführt werden, wodurch systematische oder zufällige Messabweichungen ausgeschlossen werden können.

Ferner umfasst das Verfahren folgenden vorteilhaften Schritt:
h) Validieren des Alterungszustands durch Auswerten der Spannungsgröße während der Entladung und/oder der Relaxation des elektrochemischen Energiespeichers und/oder durch Auswerten eines Spannungsverlaufs nach einem Stromsprung;

Dadurch kann der bestimmte Alterungszustand durch weitere Verfahren validiert und hochgenau bestimmt werden. Ein hochgenauer Alterungszustand bietet insbesondere für einen Fahrzeugbesitzer und/oder für einen Flottenbetreiber enorme Vorteile, was die Lebensdauer des elektrochemischen Energiespeichers oder eines elektrisch antreibbaren Fahrzeugs umfassend den elektrochemischen Energiespeicher betrifft.

Ferner umfasst das Verfahren folgende vorteilhafte Schritte:
i) Erfassen einer weiteren Spannungsgröße, die eine elektrische Spannung des elektrochemischen Energiespeichers repräsentiert;
j) Vergleichen der erfassten weiteren Spannungsgröße mit der in Schritt a) erfassten Spannungsgröße;
k) Erzeugen von Signalen zum Laden und/oder Entladen des elektrochemischen Energiespeichers basierend auf dem Ergebnis des Vergleichs;

Durch eine Energiepufferung oder Rückspeisung aus einem elektrischen Netz treten praktisch keine Verluste bei der Durchführung des erfindungsgemäßen Verfahren auf.

Vorteilhafterweise umfasst ein Diagnosegerät mindestens ein Mittel, insbesondere ein elektronisches Steuergerät, welches eingerichtet ist, die Schritte des erfindungsgemäßen Verfahrens durchzuführen.

Dadurch ist kein Eingriff in eine Steuereinheit notwendig, beispielsweise eine Steuereinheit des elektrochemischen Energiespeichers (Battery Control Unit, BCU) oder eine Steuereinheit des elektrisch antreibbaren Fahrzeugs (Vehicle Control Unit, VCU). In einer weiteren vorteilhaften Ausführung kann ein Abgleich des bestimmten Alterungszustands mit der Steuereinheit und/oder einer Infrastruktur kabelgebunden und/oder kabellos erfolgen.

Weiter wird es einer Werkstatt beispielsweise ermöglicht unter definierten Bedingungen einen zuverlässigen und hochgenauen Alterungszustand für elektrochemische Energiespeicher praktisch jedes beliebigen elektrisch antreibbaren Fahrzeugs bestimmen zu können. Anhand dieses einheitlichen Verfahrens wird eine Vergleichbarkeit zwischen unterschiedlichen elektrochemischen Energiespeichern ermöglicht, was insbesondere für mögliche Second-Life-Anwendungen der Energiespeicher interessant ist.

Vorteilhafterweise umfasst ein erfindungsgemäßes Computerprogramm Befehle, die bewirken, dass das Diagnosegerät die erfindungsgemäßen Verfahrensschritte zur Erkennung von internen Kurzschlüssen ausführt.

Vorteilhafterweise ist ein maschinenlesbares Speichermedium vorgesehen, auf dem das Computerprogramm gespeichert ist.

Vorteilhafterweise findet das Diagnosegerät Verwendung für Elektrofahrzeuge, Hybridfahrzeuge, Plug-In-Hybridfahrzeuge, Luftfahrzeuge, Pedelecs oder E-Bikes, elektrische Handwerkzeuge sowie für stationäre Speicher zur Speicherung insbesondere regenerativ gewonnener elektrischer Energie.

### Kurzbeschreibung der Figuren

Ausführungsbeispiele der Erfindung sind in der Zeichnung dargestellt und in der nachfolgenden Beschreibung näher erläutert.

Es zeigen:
Figur 1 eine erste schematische Darstellung von Spannungsverläufen unterschiedlich gealterter elektrochemischer Energiespeicher; und
Figur 2 ein Ablaufdiagramm einer Ausführungsform eines erfindungsgemäßen Verfahrens; und
Figur 3 eine schematische Darstellung eines Spannungsverlaufs nach einem Entladevorgang eines elektrochemischen Energiespeichers; und
Figur 4 eine zweite schematische Darstellung von Spannungsverläufen unterschiedlich gealterter elektrochemischer Energiespeicher.

### Detaillierte Beschreibung der Ausführungsbeispiele

Gleiche Bezugszeichen bezeichnen in allen Figuren gleiche Vorrichtungskomponenten.

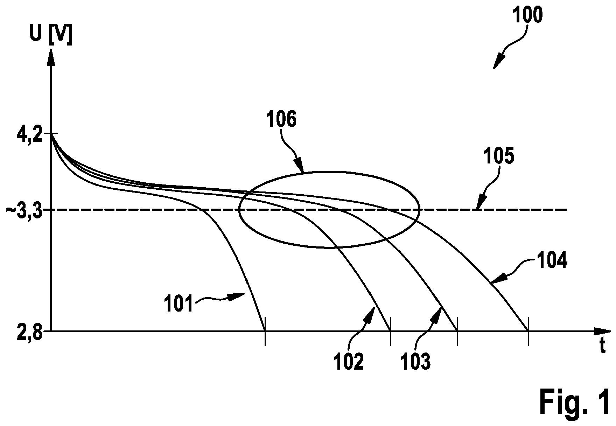

Figur 1 zeigt eine erste schematische Darstellung von Spannungsverläufen 100 unterschiedlich gealterter elektrochemischer Energiespeicher entsprechend einem jeweiligen Alterungszustand, welcher einem Verhältnis der aktuell maximal nutzbaren Kapazität zur Nennkapazität der elektrochemischen Energiespeicher entspricht. Der Spannungsverlauf 101 ist charakteristisch für einen elektrochemischen Energiespeicher mit einem Alterungszustand von 60%, der Spannungsverlauf 102 für einen elektrochemischen Energiespeicher mit einem Alterungszustand von 80%, der Spannungsverlauf 103 für einen elektrochemischen Energiespeicher mit einem Alterungszustand von 90% und der Spannungsverlauf 104 für einen elektrochemischen Energiespeicher mit einem Alterungszustand von 100%.

Eine vorgegebene elektrische Spannung 105 schneidet die Spannungsverläufe 101, 102, 103, 104 in spannungssensitiven Punkten 106 in Abhängigkeit des Alterungszustands bei einer festgelegten Temperatur.

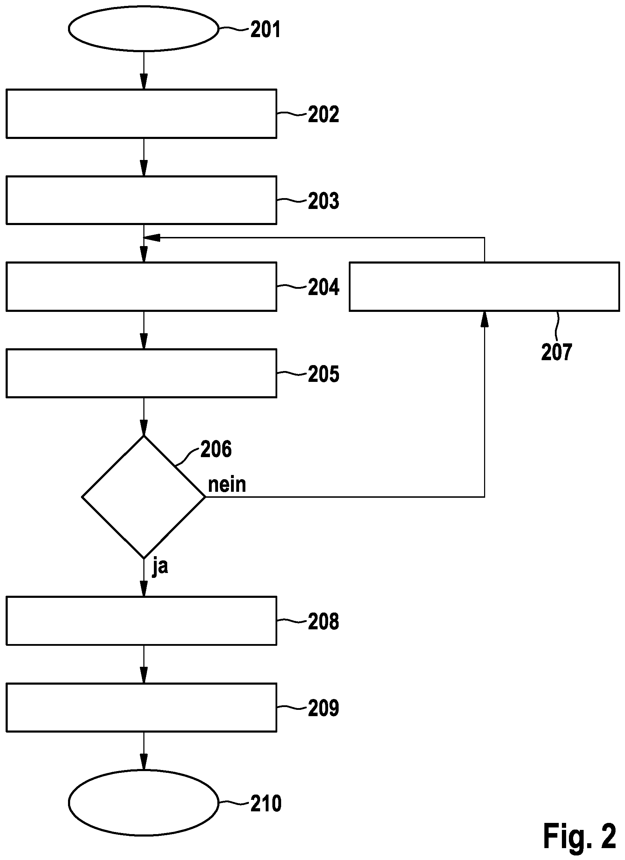

Figur 2 zeigt ein Ablaufdiagramm einer Ausführungsform eines erfindungsgemäßen Verfahrens. In Schritt 201 wird das Verfahren gestartet, beispielsweise, wenn ein Diagnosegerät an eine Diagnose-Schnittstelle eines elektrisch antreibbaren Fahrzeugs mit einem elektrochemischen Energiespeicher in einer Werkstatt angeschlossen wird.

Weiter wird in Schritt 201 eine Spannungsgröße erfasst, die eine elektrische Spannung des elektrochemischen Energiespeichers repräsentiert und die erfasste Spannungsgröße mit einer vorgegebenen Soll-Spannungsgröße verglichen.

Ferner wird eine Temperatur des elektrochemischen Energiespeichers und ein Alterungszustand aus einer Steuereinheit erfasst, beispielsweise einer Steuereinheit des elektrochemischen Energiespeichers (Battery Control Unit, BCU) oder einer Steuereinheit des elektrisch antreibbaren Fahrzeugs (Vehicle Control Unit, VCU). Die Bestimmung des Alterungszustands erfolgt vorzugsweise bei einer definierten konstanten Temperatur, beispielsweise 20°C. Dafür kann der elektrochemische Energiespeicher oder das elektrisch antreibbare Fahrzeug mit dem elektrochemischen Energiespeicher in einer Klimakammer abgestellt oder mit einem Gebläse angeströmt werden.

In Schritt 202 wird ein Signal zum Laden und/oder Entladen des elektrochemischen Energiespeichers basierend auf dem Ergebnis des Vergleichs der erfassten Spannungsgröße mit der vorgegebenen Soll-Spannungsgröße erzeugt.

Dadurch wird die elektrische Spannung des elektrochemischen Energiespeichers auf ein Spannungsniveau eingestellt, an dem eine Sensitivität der elektrischen Spannung des elektrochemischen Energiespeichers am größten ist. Die Sensitivität unterscheidet sich in Abhängigkeit einer Zellchemie des elektrochemischen Energiespeichers und die elektrische Spannung liegt nicht zwingend für alle Alterungszustände auf dem gleichen Spannungsniveau, sondern kann in Abhängigkeit des Alterungszustands variieren.

Der aus der Steuereinheit erfasste Alterungszustand dient als Referenzwert mit dem das erfindungsgemäße Verfahren startet. Anhand des erfassten Alterungszustands ergibt sich die Soll-Spannungsgröße, beispielsweise anhand von im Diagnosegerät gespeicherten technischen Daten des elektrochemischen Energiespeichers. In Abhängigkeit des Vergleichs der erfassten Spannungsgröße mit der vorgegebenen Soll-Spannungsgröße wird der elektrochemische Energiespeicher geladen oder entladen.

Das Entladen des elektrochemischen Energiespeichers geschieht im einfachsten Fall durch ein Anschalten von Verbrauchern, beispielsweise einer Klimaanlage oder Heizung, wenn eine Abweichung der aktuellen Spannungsgröße zur Soll-Spannungsgröße sehr klein ist.

Andernfalls wird der elektrochemische Energiespeicher an eine Pufferbatterie angeschlossen und entladen bis die Soll-Spannungsgröße erreicht ist.

Ferner ist auch ein Anschluss an eine Ladestation möglich, wobei die überschüssige Energie des elektrochemischen Energiespeichers in ein Stromnetz eingespeist wird. Am Ende des Verfahrens wird gepufferte bzw. rückgespeiste Energie wieder dem elektrochemischen Energiespeicher zugeführt, so dass praktisch keine Energie verloren geht und der elektrochemische Energiespeicher nach Bestimmung des Alterungszustands den gleichen Ladezustand (SOC) aufweist.

Ist die vorgegebene Soll-Spannungsgröße erreicht, so wird der Entladevorgang beendet und in Schritt 203 eine vorgegebene Zeitdauer abgewartet, in welcher der elektrochemische Energiespeicher relaxiert. Die elektrische Spannung des elektrochemischen Energiespeichers steigt dadurch an, liegt aber noch in einem Bereich nahe der Soll-Spannungsgröße.

In Schritt 204 erfolgt das Entladen des elektrochemischen Energiespeichers für eine vorgegebene Zeitdauer mit kleinen Strömen, erfindungsgemäß mit 0,1C bis 0,5C.

Wenn die Ladestation keine so kleine einstellbare Ströme zulässt, kann eine kleine Last, beispielsweise ein Verbraucher oder Widerstand, direkt an den elektrochemischen Energiespeicher angeschlossen werden. Während des Entladens wird die Spannungsgröße erfasst und in Schritt 205 ein Spannungsgradient anhand eines Verlaufs der erfassten Spannungsgröße für die vorgegebene Zeitdauer bestimmt.

In Schritt 207 wird der elektrochemische Energiespeicher mit kleinen elektrischen Strömen für eine weitere vorgegebene Zeitdauer entladen. Nach einer kurzen Messpause mit der weiteren Entladung werden die Schritte 204 und 205 wiederholt, solange sich die Spannungsgröße noch in dem vorgegebenen Spannungsbereich befindet, beispielsweise zwischen 3,4V und 3,2V. Eine bestimmte Anzahl an Wiederholungen sollte aus Toleranzgründen durchgeführt werden, hierzu wird in Schritt 206 die Anzahl an Wiederholungen mit einer vorgegebenen Anzahl von Durchläufen verglichen.

In Schritt 208 wird ein Spannungsgradient aus einem Mittelwert der bestimmten Spannungsgradienten bestimmt, wenn die vorgegebene Anzahl von Durchläufen erreicht ist.

In Schritt 209 wird der Spannungsgradient mit einem vorgegebenen Soll-Spannungsgradienten verglichen und der Alterungszustand des elektrochemischen Energiespeichers basierend auf dem Ergebnis des Vergleichs bestimmt.

In Schritt 210 wird das Verfahren beendet. In einer weiteren vorteilhaften Ausführungsform wird in Schritt 210 der Alterungszustand durch Auswerten der Spannungsgröße während der Entladung und/oder der Relaxation des elektrochemischen Energiespeichers und/oder durch Auswerten eines Spannungsverlaufs nach einem Stromsprung validiert.

In einer weiteren vorteilhaften Ausführungsform wird in Schritt 210 eine weitere Spannungsgröße erfasst, die erfasste weitere Spannungsgröße mit der in Schritt 201 erfassten Spannungsgröße verglichen und Signale zum Laden und/oder Entladen des elektrochemischen Energiespeichers basierend auf dem Ergebnis des Vergleichs erzeugt. Dadurch weist der elektrochemische Energiespeicher nach Bestimmung des Alterungszustands und Ende des Verfahrens in Schritt 210 den gleichen Ladezustand (SOC) wie bei Start des Verfahrens in Schritt 201 auf.

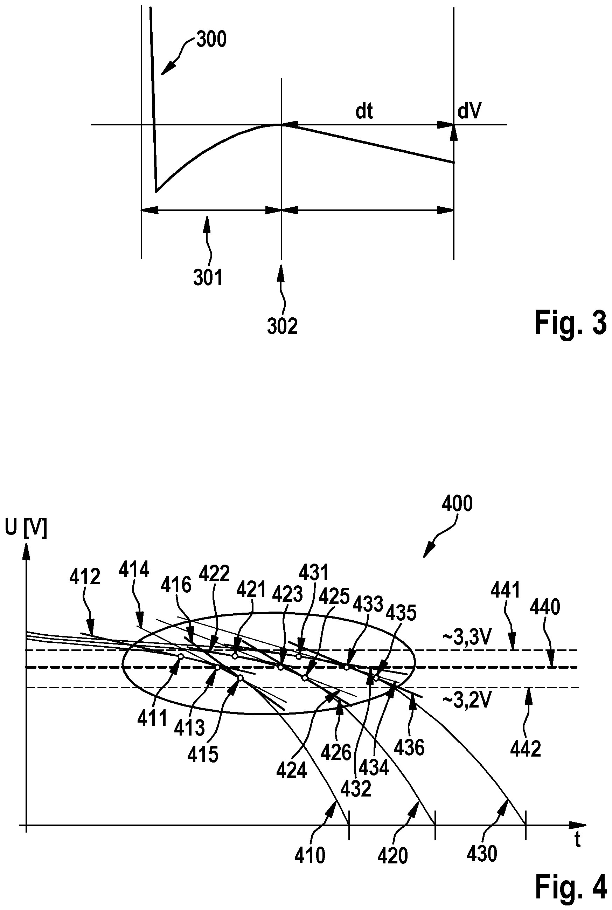

Figur 3 zeigt eine schematische Darstellung eines Spannungsverlaufs 300 nach einem Entladevorgang des elektrochemischen Energiespeichers gemäß Schritt 202. Ist die vorgegebene Soll-Spannungsgröße erreicht, so wird der Entladevorgang des elektrochemischen Energiespeichers beendet. Innerhalb einer vorgegebenen Zeitdauer 301 relaxiert der elektrochemische Energiespeicher. Die elektrische Spannung steigt während der vorgegebenen Zeitdauer in Schritt 203 wieder etwas an. Zu einem Zeitpunkt 302 kann eine Messung der elektrischen Spannung gemäß Schritt 204 erfolgen.

Figur 4 zeigt eine zweite schematische Darstellung von Spannungsverläufen 400 unterschiedlich gealterter elektrochemischer Energiespeicher entsprechend einem jeweiligen Alterungszustand, welcher einem Verhältnis der aktuell maximal nutzbaren Kapazität zur Nennkapazität der elektrochemischen Energiespeicher entspricht. Der Spannungsverlauf 410 ist charakteristisch für einen elektrochemischen Energiespeicher mit einem Alterungszustand von 80%, Der Spannungsverlauf 420 ist charakteristisch für einen elektrochemischen Energiespeicher mit einem Alterungszustand von 90%, Der Spannungsverlauf 430 ist charakteristisch für einen elektrochemischen Energiespeicher mit einem Alterungszustand von 100%.

Zur erfindungsgemäßen Bestimmung des Alterungszustands des elektrochemischen Energiespeichers wird eine elektrische Spannung 440 vorgegeben, welche die Spannungsverläufe 410, 420, 430 in spannungssensitiven Punkten 413, 423, 433 in Abhängigkeit des Alterungszustands bei einer festgelegten Temperatur schneidet. In Abhängigkeit des Alterungszustands können sich spannungssensitive Punkte 411, 413, 415, 421, 423, 425, 431, 433, 435 zwischen vorgegebenen elektrischen Spannungsgrenzen 441, 442 verschieben.

In Schritt 202 wird der elektrochemische Energiespeicher auf eine Soll-Spannungsgröße 440, beispielsweise ca. 3,3V entladen. Die elektrische Spannung steigt aufgrund der Relaxation des elektrochemischen Energiespeichers leicht an. In Schritt 204 erfolgt das Entladen des elektrochemischen Energiespeichers für eine vorgegebene Zeitdauer. In Schritt 205 wird ein erster Spannungsgradient 412, 422, 432 bestimmt. In Schritt 207 wird der elektrochemische Energiespeicher mit kleinen Strömen für eine weitere vorgegebene Zeitdauer entladen, wodurch die elektrische Spannung sinkt. Nun werden die Schritte 204 und 205 wiederholt und ein zweiter Spannungsgradient 414, 424, 434 bestimmt. In einem dritten Durchlauf wird ein dritter Spannungsgradient 416, 426, 436 bestimmt. In Schritt 208 wird der Spannungsgradient aus einem Mittelwert der bestimmten Spannungsgradienten 412, 422, 432, 414, 424, 434, 416, 426, 436 bestimmt. In Schritt 209 wird der Spannungsgradient mit einem vorgegebenen Soll-Spannungsgradienten verglichen und der Alterungszustand des elektrochemischen Energiespeichers basierend auf dem Ergebnis des Vergleichs bestimmt.

## Patentansprüche

1. Verfahren zum Bestimmen eines Alterungszustands mindestens eines elektrochemischen Energiespeichers umfassend folgende Schritte:
a) (201) Erfassen einer Spannungsgröße, die eine elektrische Spannung des elektrochemischen Energiespeichers repräsentiert;
b) Vergleichen der erfassten Spannungsgröße mit einer vorgegebenen Soll-Spannungsgröße;
c) (202) Erzeugen von Signalen zum Laden und/oder Entladen des elektrochemischen Energiespeichers basierend auf dem Ergebnis des Vergleichs bis zum Erreichen der vorgegebenen Soll-Spannungsgröße;
d) (204) Entladen des elektrochemischen Energiespeichers mit kleinen elektrischen Strömen, mit 0,1C bis 0,5C Entladerate, für eine vorgegebene Zeitdauer;
e) (205) Erfassen der Spannungsgröße während des Entladens und Bestimmen eines Spannungsgradienten der erfassten Spannungsgröße für die vorgegebene Zeitdauer;
f) Vergleichen des Spannungsgradienten mit vorgegebenen Soll-Spannungsgradienten;
g) (209) Bestimmen des Alterungszustands des elektrochemischen Energiespeichers basierend auf dem Ergebnis des Vergleichs;

2. Verfahren zum Bestimmen eines Alterungszustands eines elektrochemischen Energiespeichers gemäß Anspruch 1, ferner umfassend folgende Schritte:
a.1) (201) Erfassen einer Temperaturgröße, die eine Temperatur des elektrochemischen Energiespeichers repräsentiert;
a.2) (201) Vergleichen der erfassten Temperaturgröße mit einer vorgegebenen Soll-Temperaturgröße;
a.3) (201) Erzeugen von Signalen zum Heizen und/oder Kühlen des elektrochemischen Energiespeichers basierend auf dem Ergebnis des Vergleichs;

3. Verfahren zum Bestimmen eines Alterungszustands eines elektrochemischen Energiespeichers gemäß einem der vorhergehenden Ansprüche, ferner umfassend folgenden Schritt:
c.1) (203) Warten einer vorgegebenen Dauer zum Relaxieren des elektrochemischen Energiespeichers;

4. Verfahren zum Bestimmen eines Alterungszustands eines elektrochemischen Energiespeichers gemäß einem der vorhergehenden Ansprüche, ferner umfassend folgende Schritte:
e.1) (207) Entladen des elektrochemischen Energiespeichers mit kleinen elektrischen Strömen, mit 0,1C bis 0,5C Entladerate, für eine weitere vorgegebene Zeitdauer;
e.2) Mindestens einmaliges Wiederholen der Schritte d) und e);
e.3) (208) Bestimmen eines Spannungsgradienten aus einem Mittelwert der bestimmten Spannungsgradienten;

5. Verfahren zum Bestimmen eines Alterungszustands eines elektrochemischen Energiespeichers gemäß einem der vorhergehenden Ansprüche, ferner umfassend folgenden Schritt:
h) (210) Validieren des Alterungszustands durch Auswerten der Spannungsgröße während der Entladung und/oder der Relaxation des elektrochemischen Energiespeichers und/oder durch Auswerten eines Spannungsverlaufs nach einem Stromsprung;

6. Verfahren zum Bestimmen eines Alterungszustands eines elektrochemischen Energiespeichers gemäß einem der vorhergehenden Ansprüche, ferner umfassend folgende Schritte:
i) (210) Erfassen einer weiteren Spannungsgröße, die eine elektrische Spannung des elektrochemischen Energiespeichers repräsentiert;
j) (210) Vergleichen der erfassten weiteren Spannungsgröße mit der in Schritt a) erfassten Spannungsgröße;
k) (210) Erzeugen von Signalen zum Laden und/oder Entladen des elektrochemischen Energiespeichers basierend auf dem Ergebnis des Vergleichs;

7. Diagnosegerät umfassend mindestens ein Mittel, insbesondere ein elektronisches Steuergerät, welches eingerichtet ist, die Schritte des Verfahrens nach einem der Ansprüche 1 bis 6 durchzuführen.

8. Computerprogramm, umfassend Befehle, die bewirken, dass das Diagnosegerät nach Anspruch 7 die Verfahrensschritte nach einem der Ansprüche 1 bis 6 ausführt.

9. Maschinenlesbares Speichermedium, auf dem das Computerprogramm nach Anspruch 8 gespeichert ist.

10. Verwendung eines Diagnosegeräts gemäß Anspruch 7 für Elektrofahrzeuge, Hybridfahrzeuge, Plug-In-Hybridfahrzeuge, Luftfahrzeuge, Pedelecs oder E-Bikes, elektrische Handwerkzeuge sowie für stationäre Speicher zur Speicherung insbesondere regenerativ gewonnener elektrischer Energie.

## Claims

1. Method for determining a state of health of at least one electrochemical energy store, comprising the following steps:
a) (201) measuring a voltage value which represents an electrical voltage of the electrochemical energy store;
b) comparing the measured voltage value with a predefined setpoint voltage value;
c) (202) generating signals for charging and/or discharging the electrochemical energy store on the basis of the result of the comparison up until the predefined setpoint voltage value is reached;
d) (204) discharging the electrochemical energy store with small electrical currents, at a discharge rate of 0.1 C to 0.5 C, for a predefined period of time;
e) (205) measuring the voltage value during the discharging and determining a voltage gradient of the measured voltage value for the predefined period of time;
f) comparing the voltage gradient with predefined setpoint voltage gradients;
g) (209) determining the state of health of the electrochemical energy store on the basis of the result of the comparison.

2. Method for determining a state of health of an electrochemical energy store according to Claim 1, further comprising the following steps:
a.1) (201) measuring a temperature value which represents a temperature of the electrochemical energy store;
a.2) (201) comparing the measured temperature value with a predefined setpoint temperature value;
a.3) (201) generating signals for heating and/or cooling the electrochemical energy store on the basis of the result of the comparison.

3. Method for determining a state of health of an electrochemical energy store according to either of the preceding claims, further comprising the following step:
c.1) (203) waiting for a predefined duration to relax the electrochemical energy store.

4. Method for determining a state of health of an electrochemical energy store according to one of the preceding claims, further comprising the following steps:
e.1) (207) discharging the electrochemical energy store with small electrical currents, at a discharge rate of 0.1 C to 0.5 C, for a further predefined period of time;
e.2) repeating steps d) and e) at least once;
e.3) (208) determining a voltage gradient from an average of the determined voltage gradients.

5. Method for determining a state of health of an electrochemical energy store according to one of the preceding claims, further comprising the following step:
h) (210) validating the state of health by evaluating the voltage value during the discharging and/or the relaxation of the electrochemical energy store and/or by evaluating a voltage curve after a surge in current.

6. Method for determining a state of health of an electrochemical energy store according to one of the preceding claims, further comprising the following steps:
i) (210) measuring a further voltage value which represents an electrical voltage of the electrochemical energy store;
j) (210) comparing the measured further voltage value with the voltage value measured in step a);
k) (210) generating signals for charging and/or discharging the electrochemical energy store on the basis of the result of the comparison.

7. Diagnosis device comprising at least one means, in particular an electronic control device, which is configured to carry out the steps of the method according to one of Claims 1 to 6.

8. Computer program comprising commands which cause the diagnosis device according to Claim 7 to perform the method steps according to one of Claims 1 to 6.

9. Machine-readable storage medium on which the computer program according to Claim 8 is stored.

10. Use of a diagnosis device according to Claim 7 for electric vehicles, hybrid vehicles, plug-in hybrid vehicles, aircraft, pedelecs or e-bikes, electric hand tools and for stationary stores for storing in particular regeneratively produced electrical energy.

## Revendications

1. Procédé permettant de déterminer un état de vieillissement d'au moins un accumulateur d'énergie électrochimique, comprenant les étapes suivantes consistant à :
a) (201) détecter une grandeur de tension qui représente une tension électrique de l'accumulateur d'énergie électrochimique ;
b) comparer la grandeur de tension détectée avec une grandeur de tension de consigne prédéfinie ;
c) (202) produire des signaux pour charger et/ou décharger l'accumulateur d'énergie électrochimique sur la base du résultat de la comparaison jusqu'à ce que la grandeur de tension de consigne prédéfinie soit atteinte ;
d) (204) décharger l'accumulateur d'énergie électrochimique par de petits courants électriques, à un taux de décharge de 0,1 C à 0,5C, pendant une durée prédéfinie ;
e) (205) détecter la grandeur de tension pendant la décharge, et déterminer un gradient de tension de la grandeur de tension détectée pendant la durée prédéfinie ;
f) comparer le gradient de tension avec des gradients de tension de consigne prédéfinis ;
g) (209) déterminer l'état de vieillissement de l'accumulateur d'énergie électrochimique sur la base du résultat de la comparaison.

2. Procédé permettant de déterminer un état de vieillissement d'un accumulateur d'énergie électrochimique selon la revendication 1, comprenant en outre les étapes suivantes consistant à :
a.1) (201) détecter une grandeur de température qui représente une température de l'accumulateur d'énergie électrochimique ;
a.2) (201) comparer la grandeur de température détectée avec une grandeur de température de consigne prédéfinie ;
a.3) (201) produire des signaux pour chauffer et/ou refroidir l'accumulateur d'énergie électrochimique sur la base du résultat de la comparaison.

3. Procédé permettant de déterminer un état de vieillissement d'un accumulateur d'énergie électrochimique selon l'une quelconque des revendications précédentes, comprenant en outre l'étape suivante consistant à :
c.1) (203) attendre pendant une durée prédéfinie pour relaxer l'accumulateur d'énergie électrochimique.

4. Procédé permettant de déterminer un état de vieillissement d'un accumulateur d'énergie électrochimique selon l'une quelconque des revendications précédentes, comprenant en outre les étapes suivantes consistant à :
e.1) (207) décharger l'accumulateur d'énergie électrochimique par de petits courants électriques, à un taux de décharge de 0,1 C à 0,5C, pendant une durée prédéfinie supplémentaire ;
e.2) répéter au moins une fois les étapes d) et e) ;
e.3) (208) déterminer un gradient de tension à partir d'une moyenne des gradients de tension déterminés.

5. Procédé permettant de déterminer un état de vieillissement d'un accumulateur d'énergie électrochimique selon l'une quelconque des revendications précédentes, comprenant en outre l'étape suivante consistant à :
h) (210) valider l'état de vieillissement par l'évaluation de la grandeur de tension pendant la recharge et/ou la relaxation de l'accumulateur d'énergie électrochimique et/ou par l'évaluation d'une courbe de tension après une saute de courant.

6. Procédé permettant de déterminer un état de vieillissement d'un accumulateur d'énergie électrochimique selon l'une quelconque des revendications précédentes, comprenant en outre les étapes suivantes consistant à :
i) (210) détecter une grandeur de tension supplémentaire qui représente une tension électrique de l'accumulateur d'énergie électrochimique ;
j) (210) comparer la grandeur de tension supplémentaire détectée avec la grandeur de tension détectée à l'étape a) ;
k) (210) produire des signaux pour charger et/ou décharger l'accumulateur d'énergie électrochimique sur la base du résultat de la comparaison.

7. Appareil de diagnostic, comprenant au moins un moyen, en particulier un appareil de commande électronique, qui est conçu pour exécuter les étapes du procédé selon l'une quelconque des revendications 1 à 6.

8. Programme informatique, comprenant des instructions qui font que l'appareil de diagnostic selon la revendication 7 exécute les étapes de procédé selon l'une quelconque des revendications 1 à 6.

9. Support de stockage lisible par machine, sur lequel est stocké le programme informatique selon la revendication 8.

10. Utilisation d'un appareil de diagnostic selon la revendication 7 pour des véhicules électriques, des véhicules hybrides, des véhicules hybrides rechargeables, des aéronefs, des vélos à assistance électrique ou des vélos électriques, des outils à main électriques, ainsi que pour des accumulateurs stationnaires permettant de stocker en particulier de l'énergie électrique obtenue par régénération.
